Europäisches Patentamt

European Patent Office

Office européen des brevets

(11) Publication number: **0 176 770**
**B1**

(12) **EUROPEAN PATENT SPECIFICATION**

(45) Date of publication of patent specification: **19.12.90**

(21) Application number: **85110886.0**

(22) Date of filing: **29.08.85**

(51) Int. Cl.⁵: **B 01 J 12/00** // C30B25/00, C30B29/62

(54) **Fluid wall reactor.**

(30) Priority: **05.09.84 US 647958**
**05.09.84 US 648403**
**16.08.85 US 766608**
**16.08.85 US 766844**

(43) Date of publication of application:
**09.04.86 Bulletin 86/15**

(45) Publication of the grant of the patent:
**19.12.90 Bulletin 90/51**

(84) Designated Contracting States:
**AT BE CH DE FR GB IT LI LU NL SE**

(56) References cited:
**US-A-2 823 979**
**US-A-3 203 763**
**US-A-4 012 201**
**US-A-4 199 545**

(73) Proprietor: **J.M. HUBER CORPORATION**
**Brown's Dock and Navesink River Roads**
**Locust New Jersey (US)**

(72) Inventor: **Schramm, Dale E.**
**301 Sarasota**
**Borger Texas 79007 (US)**

(74) Representative: **Henkel, Feiler, Hänzel & Partner**
**Möhlstrasse 37**
**D-8000 München 80 (DE)**

Courier Press, Leamington Spa, England.

# EP 0 176 770 B1

**Description**

Field of the invention

The present invention relates to a reactor tube for a high temperature fluid-wall reactor, and, more particularly, to a reactor tube for a reactor wherein the reaction zone spaced interiorly of the reaction tube is substantially heated by radiant energy passing through a fluid wall.

Background of the invention

The present invention relates to a reactor tube for forming a high-temperature fluid-wall reactor, and to the process for enabling such a reactor tube to form an integral fluid wall for preventing reactants from contacting the interior surface of the tube. The reactor of the present invention may utilize radiation coupling, so that electrodes radiate heat to the reactor tube, which is heated to incandescence and accordingly radiates energy inwardly to maintain the desired chemical reaction within the protective fluid-wall blanket.

Heat generating reactors have been employed in various industrial processes, but conventional reactors utilizing convection and/or conduction generally are not suitable for many high temperature reactions. At elevated temperatures, the heat transfer material for such conventional reactors generally reacts with the feedstock and fails, or reactants accumulate on the heat transfer walls of such conventional reactors, thereby substantially reducing the efficiency of the thermal process. Examples of such conventional reactors are found in US—A—2 769 772, 2 926 073, and 3 565 766.

The US—A—2 750 260 discloses a technique for manufacturing titanium dioxide pigment by combustion of titanium tetrachloride with oxygen. The deposition of titanium dioxide particles on the walls of the cooling zone of the reaction apparatus is suppressed by slowly diffusing a purge gas through a porous wall. The mass of the purged gas is considered controlling rather than the gas pressure or pore size of the interstices through the wall, although the pore size less than 1 mm in diameter is preferred. In the combustion zone temperatures may reach 1600°C, although in the cooling zone where the reactant deposition is suppressed, the temperature is in the range of only 600°C.

The US—A—3 499 730 discloses a combustion reactor for producing pigmentary titanium dioxide by the combustion of titanium tetrachloride in the presence of an auxiliary flame. The combustion reaction is carried out in a central flame confined within a foraminous wall tube. In the reaction zone, the cooling zone, and the recycling zone, a selected gas passes through the foraminous wall of the tube to form a barrier layer of gas which keeps particles of titanium dioxide formed in the central flame away from the wall of the tube. The gas passing through the foraminous wall of the tube also prevents the tube from reaching the temperature of the reaction zone, so that the wall may be maintained at substantially room temperature. The foraminous wall of the tube may thus be made of steel, aluminum or other metal, and perforations in the tube consists of from 2% to 40% of the wall surface. The US—A—4 044 117 discloses a fluid-wall reactor for carrying out chemical reactions at temperatures significantly higher than that disclosed in the earlier reference patents. The reactor includes electrodes surrounded by a heat shield for heating a reactor tube made of a refractory material. The reactor tube is heated to a high temperature, and in turn emits sufficient radiant energy to initiate and sustain a desired chemical reaction which occurs within the interior of the reaction tube. Since the Matovich technique employs radiant energy rather than conduction or convection, a reactor tube material having poor thermal conductivity but relatively high temperature integrity may be utilized to form the reaction tube. This "radiation coupling" technique and its advantages over conventional reactors are fully discussed in the US—A—4 044 117.

In an attempt to alleviate the reactant and tube material reaction, and to reduce the accumulation of reactants on the interior surface of the reaction tube, Matovich utilizes a porous tube material to permit an inert gas to pass through the tube and provide a protective fluid wall for the inner surface of the tube. Various wall construction materials and types of perforations are disclosed in the US—A—4 044 117, although the reactor tube is preferably made of a porous refractory material having pore diameters in the range of from about 0.025 mm to 0.508 mm.

The reactor disclosed in the US—A—4 044 117 is thus considered a significant advancement over the prior art, since it teaches the generation of substantially increased reaction temperatures without significant deposition of reactants on the inner surface of the reactor tube. A suitable porous tube for such a reactor may be fabricated from graphite, with a wall thickness of about 19 mm. Porous graphite is usually made by sintering particles of graphite coated with a carbonizable adhesive to bond the particles together. Interstices between the particles form a network of random pores through which gas can pass. It is both difficult and expensive, however, to maintain uniform porosity of the graphite material. In order to maintain reasonable porosity uniformity, the porous graphite tubes may be produced in small sections or blocks having a thickness greater than that desired. Known commercially available porous graphite tubes, not specifically intended for fluid wall reactors, are limited to a diameter of approximately 356 mm. Since the desired fluid wall within the tube may be approximately 25 to 51 mm thick, the diameter of the inner reaction zone is limited to sizes which are frequently not commercially attractive.

The reactor of the US—A—4 044 117, although generally considered adequate for small-scale experimental work, has a number of significant drawbacks when operated on an industrial scale. Perhaps the most serious drawback is its inability to maintain a sufficient fluid wall to prevent reactants from

2

contacting and reacting with the inner surface of the tube, especially at the location where the feedstock is input to the reaction zone. At commercial feedstock input rates, the reactants and porous tube chemically react, thus substantially reducing the life of the reaction tube. Moreover, engagement of the reactants with the porous tube tends to plug the interstices through the porous tube, thereby further reducing the effectiveness of the fluid wall and decreasing tube life.

In industrial applications, the porous reactor tube of Matovich also is not capable of efficiently transmitting heat to the reaction zone in order to sustain many desired chemical reactions. For example, when a hydrocarbon oil was introduced into a commercial embodiment of the reactor at a relatively low flow rate, oil may be decomposed into hydrogen and a high-quality carbon black. However, when it was attempted to increase the flow to a reasonable production rate, the produced carbon black became oily and otherwise deteriorated in quality. It was found that although the electrodes of the reactor were operating at a temperature of about 2200°C, the temperature of the inner surface of the reactor tube was only about 1700°C. Since the intensity of radiant energy emitted by a surface is approximately proportional to the absolute temperature raised to the fourth power, this decrease causes a reduction in the intensity of radiant energy by a factor of roughly 0.4. As a result of the reduced intensity of radiant energy in the reaction chamber, the decomposition reaction did not proceed to completion, thereby giving rise to carbon black of inferior quality. Also, after a relatively short reaction time of several hours, the porous tube failed, largely due to chemical reactions between the porous wall material and both the reactants and injected gas for the fluid wall. Some of the pores through the tube were plugged, and thus it was determined that the porous tube did not effectively maintain the desired fluid wall.

The number of chemical reactions which can be sufficiently commercialized with a reactor utilizing the porous tube of Matovich is therefore limited, because of its inability to maintain an effective fluid wall (which severely limits the life of the reactor tube), and because of its thermal inefficiency (due to the difference between the electrode temperature and the reaction temperature).

Further limitations to the Matovich reactor include the significant consumption of inert gas required to maintain a reasonable fluid wall. Significant consumption of nitrogen, a suitable inert gas, increases the reactor operating costs and demands large capacity downstream equipment for purifying the nitrogen for discharge. At elevated temperatures, nitrogen is not totally inert and does react with the graphite tube material, which structurally weakens the tube. Because of its porous nature, this nitrogen/graphite reaction occurs throughout the tube, and substantially limits the effective life of a porous tube. Finally, the nitrogen passing through the porous tube reaches substantial thermal equilibrium with the tube, thereby increasing the exit gas temperature which, in some reaction processes, must then be subsequently lowered.

From the US—A—4 199 545 a fluid wall reactor is known, the cylindrical-shaped reactor tube of which is made from a porous refractory material which is permeable to gas flow. The use of a porous reactor tube, however, has a number of drawbacks which already have been discussed above along the US—A—4 044 117.

The US—A—3 203 763 is concerned with maintaining the wall of a fluid wall reactor relatively cool to effectively prevent oxide scale formation. The cooling of the reactor wall is accomplished by providing passageways in the walls through which a gas coolant may pass and thereby provide the desired "quinching action". For that purpose various types of passageways are said to be useful, including holes, slots, etc., the only requirement of these passageways being a sufficient size and number to simply afford the free flow of passage of gas through the openings to cool the wall.

The disadvantages of the prior art are overcome by the present invention, and an improved high temperature fluid wall reactor is hereinafter disclosed utilizing a perforated reactor tube. Also disclosed is an improved process for forming an effective fluid wall within a high-temperature reactor by forming a plurality of gas jets which overlap to form the protective fluid wall but do not disturb flow within the reaction zone.

Summary of the invention

A perforated reactor tube is provided for a high-temperature fluid-wall reactor. The reactor tube of the present invention permits an efficient transfer of heat from the heating elements through the reactor tube and to reactants passing through the tube. Inert gas passing through perforations in the tube enables the formation of an effective fluid wall to protect the interior surface of the tube from reactant chemical attack, and prevents reactant accumulation on the tube.

The reactor tube of the invention preferably has a generally cylindrical shape and is made of a refractory material which permits the tube to be heated to incandescence. At least a length of the reactor tube is perforated to permit a gas which is substantially inert with respect to the tube material to pass through the tube to form a protective fluid wall between the tube and the inner reaction zone. Perforations are located, shaped and dimensioned such that inert gas jets comprise a portion of the fluid wall, with each gas jet having a substantially radial-directed momentum sufficient to repel the reactants. The gas jets overlap to form a continuous protective fluid wall, but do not disturb flow within the reaction zone.

The reactor tube of the present invention may be fabricated from solid graphite, which can routinely withstand temperatures of 2480°C, and can withstand temperatures of 3040°C or even higher for shorter time periods. Solid graphite tubes may be fabricated relatively economically, with suitable perforations added at selected locations.

3

The wall of the reactor tube is preferably made as thin as practical, consistent with the requirement that the reactor tube have sufficient mechanical strength to bear up under the operating conditions of the reactor. The increased thermal conductivity of a solid wall tube material compared to a porous wall tube material, in addition to the reduced thickness of the tube wall, substantially reduces the thermal impedence presented by the tube. The perforated reactor tube of the present invention thus more efficiently transfers heat from the electrodes of the reactor to reactants passing through the reactor tube. Refractory materials other than graphite may also be used to fabricate the reactor tube, provided the material retains sufficient structural integrity at the intended operating temperatures.

According to one embodiment of the present invention, a 1.2 m long reactor tube having an internal diameter of 324 cm and a wall thickness of 6 mm is utilized. Perforations in the wall of the reactor tube are circular with a cross-sectional diameter of .76 mm. The holes are located in a triangular lattice pattern with a spacing of 2.54 mm between hole centers. The perforations extend through the wall of the reactor tube in a direction substantially perpendicular to the wall. Approximately 3.4 scmm of nitrogen is provided as the inert gas, and passes through the perforations creating a pressure differential of approximately 2.5 gm./sq.cm. of water at a reactor tube temperature of approximately 2200°C.

The diameter and spacing of the holes, the thickness of the wall, and the pressure differential cooperate to form a plurality of inert gas jets each having a substantial conical configuration, with the jet apex substantially adjacent the exit opening of the perforation. Although the gas dynamics of the fluid wall are not fully understood, especially because of the elevated temperatures, the momentum of each jetstream is believed to be sufficiently radially-directed to repel reactant particles. Moreover, the inert gas jets maintain such a momentum at sufficient distance from the perforation exits, so that the jets overlap creating an integral fluid wall. It is also believed, however, that the radially-directed velocity of the jets is minimal or non-existant before the jets engage the intended reaction zone, so that the jets do not disturb flow within the reaction zone.

At the elevated temperatures previously noted, the injected inert gas achieves substantially laminar flow as the gas is swept downstream from the injection points. Laminar flow of the inert gas at a point downstream from the perforations enables the gas to maintain the desired fluid wall so that downstream perforations may be eliminated. At cooler temperatures, however, the gas is less reactive with the tube material. It may therefore be advantageous in certain cases for an upstream, and relatively cool, section of the reactor tube to be perforated while an adjacent downstream, and relatively hot, section of the reactor tube is unperforated. Also, successive sections of perforated and unperforated reactor tube may be provided in a single reactor, especially if the reactor zone is extremely long.

The reactor tube of the present invention may be fabricated in sizes sufficient to enable commercial production operations requiring high-temperature chemical processes, e.g., the production of carbon black or the destruction of hazardous waste materials. The perforated reactor tube may be used to successfully maintain a sufficient inert gas fluid wall so that the reactants do not come into engagement with the inner surface of the tube. The solid construction of the reactor tube, and the use of perforated sections only in relatively cool zones, contribute to a markedly increased tube life compared to porous graphite tubes. Moreover, the process of injecting gas through the perforations in the solid tube according to the present invention requires substantially less inert gas than was previously utilized to achieve a fluid wall using a porous tube, thus lowering reactor operating costs. Moreover, the perforated tube of the present invention has a higher resistance to chemical attack than the porous construction tubes, thereby also contributing to longer reactor tube life.

A novel cobweb whisker fiber and production method for some is further provided. In one embodiment of the invention, a feedstock comprised of 94.3% silicon dioxide sand, 5% carbon black, and 0.7% transformer oil are mixed until the sand particles are uniformly coated and the mixture is free flowing.

These and other features and advantages of the present invention will become apparent from the following detailed description, wherein reference is made to the Figures in the accompanying drawings.

In the drawings

Figure 1 is a simplified pictorial view of one embodiment of a reactor assembly including the reactor tube of the present invention.

Figure 2 is a pictorial view, partially in cross-section of a suitable high-temperature reactor section of the reactor assembly generally depicted in Figure 1.

Figure 3 is a more detailed pictorial view of a suitable perforated reactor tube according to the present invention.

Figure 4 is a cross-sectional view of a portion of the wall of a suitable reactor tube.

Figures 5 and 6 are each simplified pictorial views of alternate embodiments of reactor tubes within suitable reaction chambers.

Detailed description of preferred embodiments

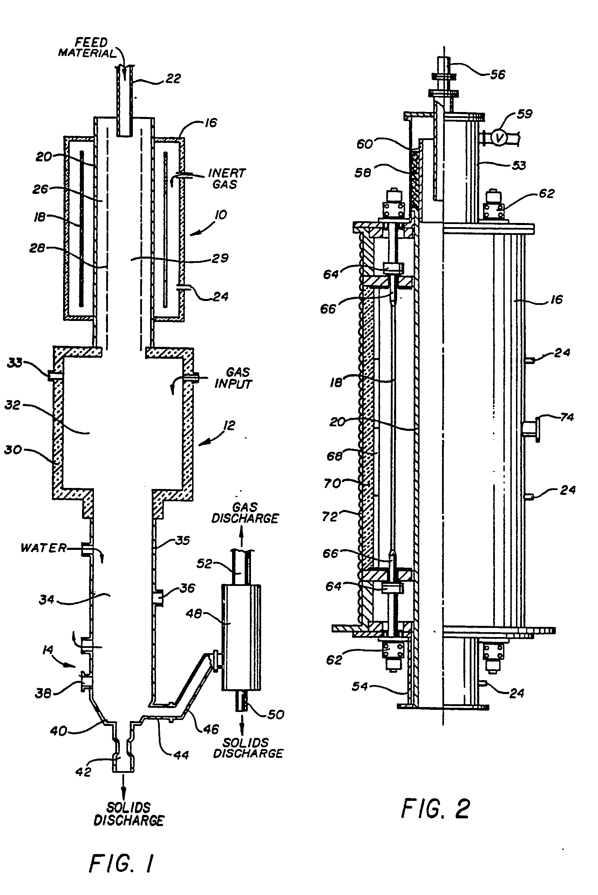

Referring to Figure 1, a simplified view of high temperature reactor equipment is depicted, including a reactor section 10, a post reactor treatment section 12, and a water-cooled treatment section or heat exchanger 14. As described further below, reactor material (feedstock) and inert gas are (a) fed into the reactor housing 10, wherein the feedstock is heated to a high temperature to cause a desired chemical reaction, (b) passed downward into the insulated housing 12, wherein further decomposition of the reactant may occur, and (c) passed downward through heat exchanger 14, wherein the temperature of the gas and reactants are lowered for subsequent handling. For the present, it should be understood that numerous chemical reactions may be ideally suited for the apparatus herein described. The equipment shown in Figure 1 may be used commercially, for example, to generate carbon black from hydrocarbons or to decompose hazardous waste material.

The reactor section 10 includes a generally cylindrical outer housing 16, a plurality of elongate heating electrodes 18 spaced inwardly of the housing 16, and a generally cylindrical reactor tube 20. The selected feed material may be input to the reactor by feed tube 22. The electrodes 18 generate radiant heat which is reflected inwardly by the housing 16, causing the reactor tube 20 to be heated to incandescence. Radiant heat from reactor tube 20 in turn radiates energy inwardly to sustain the desired chemical reaction within the reactor tube. Inert gas is input without housing 16 through ports 24, and passes through a plurality of apertures in the reactor tube to form an inert gas fluid wall or blanket 26 on the inner surface of the reactor tube. The inert gas blanket thus encompasses the generally cylindrical-shaped reaction zone 29 within the reactor tube, with the interface 28 between the inert gas and the reactor zone shown representatively in Figure 1 by dashed lines.

Referring briefly to the other equipment illustrated in Figure 1, the post reaction treatment section 12 includes a cylindrical insulated housing 30 which forms a PRTZ chamber 32. Employment of section 12 depends on the desired chemical reaction, and section 12 need not be provided in all cases. Basically, the PRTZ chamber 32 adds "residence time" to the products coming from the reactor section 10, so that further lower temperature decomposition of the gases may occur within the section 12. By way of example, the reactants may be heated to approximately 2430°C to 2650°C within the reactor section 10, and may be maintained at a temperature of between 980°C to 1650°C within the chamber 32. If desired, various gas ports 33 may be provided for injecting selected gases into the chamber 32.

The reactants and gas are subsequently input to a water-cooled heat exchanger 14 confined within a cylindrical housing 35. Conventional heat exchanger tubes (not illustrated) may thus be provided within the chamber 34, with water inlet and outlet ports 36 connecting the heat exchanger tubes to water flow lines. (Alternatively, heat exchanger coils may be provided on the outside of the housing). With reference to the exemplary temperatures listed above, gases and reactants from the chamber 32 may conventionally be lowered by the heat exchanger 14 to approximately 260°C to 650°C for further handling. If desired, a gas exit port 38 may be provided from the housing 35, although more conventionally a gas exit port 44 may be provided from transition section 40. At the bottom of the transition section 40, a discharge control 42 may be provided for discharging solid material from the chamber 34, although no appreciable gas flow from control 42 occurs. The input gases as well as the reactor-generated gases are transmitted by conduit 46 to cyclone separator 48, which in turn separates the fine particles for discharge through port 50 and discharges gas to a bag filter (not depicted) for a final cleaning operation.

It will be noted that as will be discussed, the fiber material thus produced may oxidize readily. Thus, in cases when it is desired to preserve the material in a non-oxidizing atmosphere, the fibers could be collected in a wet scrubber, in a resin or could be sprayed with a protective coating such as oil to prevent oxidization of the final product.

Referring to Figure 2, a more detailed, although still highly simplified, pictorial view of the reactor section 10 is shown, partially in cross-section. Attached to the ends of cylindrical housing 16 are reduced diameter input cylindrical housing 53 and reduced diameter transition housing 54, each axially aligned with the axis of the housing 16. The housing 53 supports a water cooled, adjustable feed tube mechanism 56 which supplies feedstock for the desired chemical reaction. A suitable feed tube mechanism is described in detail in U.S. Serial No. 06/647 948, filed on September 5, 1984.

The transition housing 54 provides both a physical and fluid connection between the reactor section 10 and the post reactor treatment section 12. A suitable packing material 58 may be provided between the tubular drip lip member 60 and the inner wall of the housing 53. Drip lip 60 may be fabricated from solid graphite, and serves both as an accumulation surfaces for melted solids and vapors which may condense within the housing 53, and a drip ring spaced from the reactor tube 20 so that melted solids and condensed liquids do not flow down onto the reactor tube.

Electrical power for heating the reactor may be supplied through the power champ connectors 62, which are connected to associated power feedthrough subassemblies 64. A plurality of elongate resistance electrodes 18 preferably are uniformly spaced about the interior of the housing 16, and each electrode may be physically supported by and electrically connected at its ends to a suitable electrical connector 66.

As previously noted, housing 16 reflects radiation inwardly, so that a substantial portion of the radiant energy from electrodes 18 is used to heat the perforated tube 20. More particularly, housing 16 includes a cylindrical shaped radiation shield 68, a cylindrical insulator layer 70, and a cooling jacket 72. The insulator layer 70 and cooling jacket 72 serve to prevent significant temperature increases in the housing wall, and thereby maintain the structural integrity of the housing 16 and minimize housing warpage. A plurality of ports 74 secured to the housing 16 may be provided for attaching suitable sensing equipment to monitor conditions within the reactor.

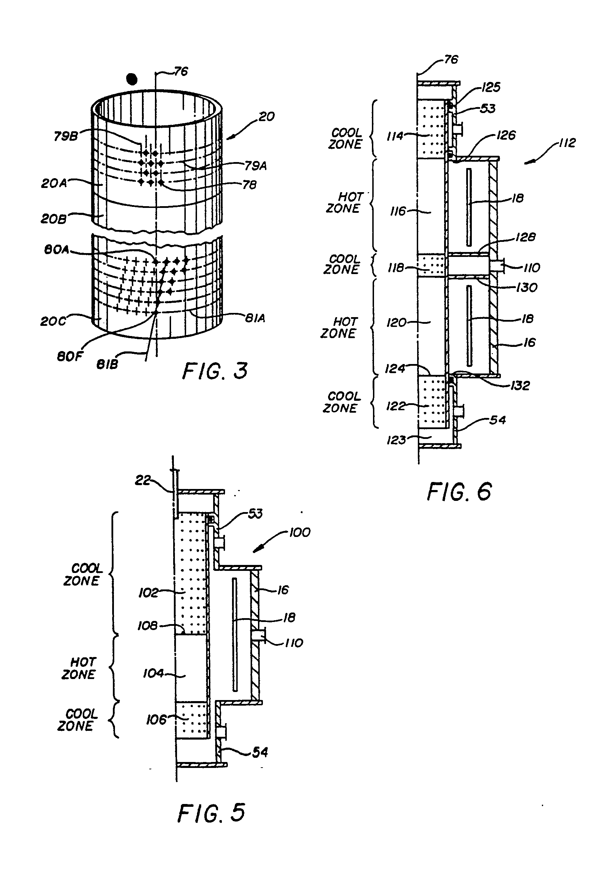

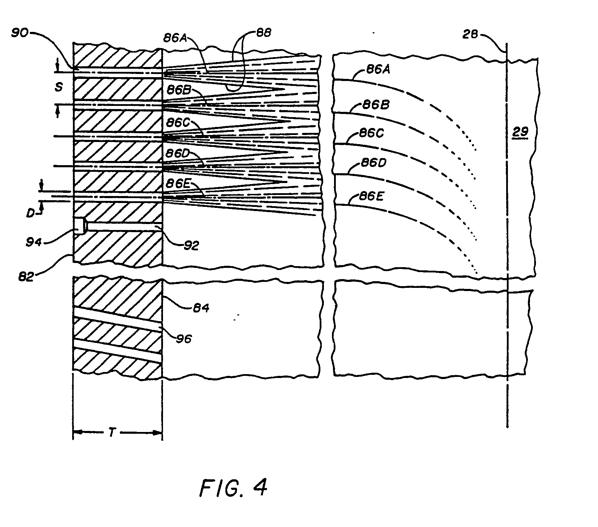

Figure 3 is a pictorial view of a suitable reactor tube 20 according to the present invention. Reactor tube 20 may be fabricated from a solid (non-porous) reactor material having a thermal conductivity in the range

5

of 27.7 to 36.3 watt/meter°C at 2200°C, and a material strength of at least 176 kg/sq.cm. Solid graphite tubes having an inner diameter of 324 mm and a wall thickness of 6 mm have been successfully employed. At room temperature, solid graphite has a material strength of approximately 351 kg/sq.cm. compared to approximately 35 kg/sq.cm. for porous graphite, so that the structural integrity of the tube is substantially increased by using solid graphite. The perforations in the tube constitute only about 7% of the total tube area, so that the thermal conductivity of the perforated graphite tube is still approximately 32.9 watts/meter°C at 2200°C. This increase in thermal conductivity (approximately 3 to 5 times compared to a porous graphite) results in a significant increase in the temperature generated within the reaction zone. Further reduction in the thickness of the perforated graphite tube may be possible, although a significant advantage of the perforated tube 20 compared to the porous graphite tube is its substantially increased reactor life, and the tube life would probably be reduced if a thinner wall perforated tube were utilized. Also, tubes may be periodically removed from the reactor and cleaned (because of a buildup on the outside of the tube discussed subsequently), and much more care would be required when handling thinner wall tubes.

Referring to reactor tube 20 depicted in Figure 3, the tube comprises sections 20A, 20B, and 20C, with each section being identical except for the perforations. In section 20A, the perforations 78 through the tube wall are provided along circumferential lines 79A and along vertical columns 79B. (Although perforations would normally be uniformly provided around the periphery of the tube sections 20A and 20C, only portions of the tube are shown to be perforated for drawing clarity.) The holes 78 may be uniformly spaced from each other on the tube sections 20A so that the holes define lattice points of a triangular lattice pattern wrapped around the cylindrical tube. More particularly, holes 78 may be cylindrical holes having a hole axis substantially aligned with the center line 76 of the tube 20. (The holes may be "gang drilled" in patterns 6 to 12 columns wide, so that the axis of each hole may not be directly in line with the center line 76). The holes 78 may be spaced so that a uniform distance is provided between each of the rows 79A, which distance is approximately 1.55 times the uniform distance provided between each of the columns 79B, and the holes 78 are thus uniformly spaced from each other in a triangular lattice pattern.

Tube section 20C includes cylindrical-shaped holes 80 similar to holes 78, except that holes 80 define lattice points of a rhomboid lattice pattern and are provided along circumferential lines 81A and along spiral columns 81B. The spiral or helical lines 81B may also be spaced at equal intervals, with a suitable pitch for the helical lines 81B resulting in hole 80A (spaced five or more rows above hole 80F) being directly vertical over hole 80F. Advantages of a triangular, rhomboid and square lattice pattern are discussed subsequently. For the present however, it should be understood that exemplary cylindrical holes 78 and 80 may have a diameter of .76 mm and may be spaced on the tube exterior surface at centerline spacings between holes of 2.54 mm.

Using an exemplary perforated tube having a 324 mm internal diameter (as previously described) which is 1.2 m long and is perforated with holes having a diameter and spacing as described above and arranged in the configuration of holes 78 throughout the length of the tube, a suitable method for forming a fluid wall will be discussed. After the heating elements have radiated the tube 20 to its intended operating temperature, pressurized inert gas may be injected into the interior of the housing 16. Gases typically have a very low radiation absorption rate, so that the gas would not necessarily be heated to the temperature of the heating elements.

A pressure differential of between 1.3 to 10.1 gm/sq.cm of water may be created as the gas is passed through the perforations in the tube. This pressure differential preferably is sufficient to insure a uniform flow through the perforations in the tube, but is not so high as to cause unnecessary turbulence in the interior of the tube. Typically, gas may be injected into the tube described above at rates of between 1.1 to 6.8 scmm, and normally below 4.2 scmm. If desired, a low volume of sweep gas less than .57 scmm, may be input into the top of the reactor through control valve 59 (see Figure 2).

It is believed that flow in the tube perforations is laminar. Depending on the assumed temperature of the gas in the perforations and the gas flow rate, the exit velocity of the jet has been approximated at between .30 to 15.2 meters per second. It is presently believed that the jetstreams commencing at the exit of the perforations are also laminar, although portions of these jetstreams could also be turbulent due, in part, to intermixing of jetstreams and cross-flow (axial flow) of gas injected upstream. Each inert gas jetstream is directed downward through the tube, as explained below. If the perforations in the tube are discontinued downstream, inert gas flow downstream of the perforations is believed to be substantially laminar. Thus, the combination of radially-directed gas jets and the subsequent axially moving inert gas form the desired fluid wall to enable the reaction process to occur without having reactants contact the interior surface of the tube.

Tube sections may be from less than one foot to several feet in length, and perforations are normally uniformly provided substantially along the length of each perforated section and uniformly about the circumference of each perforated section. Typically, thousands of holes would be provided in a perforated tube section, and thus substantial costs may be incurred when manufacturing perforated tubes according to the present invention.

The selection of a suitable hole diameter and hole spacing for the perforations will depend on the particular reaction process desired. If the perforated area per unit surface area remains constant, a decreased hole spacing will increase the number of holes and should theoretically provide a more uniform inert gas blanket. If the same flow rate of inert gas is utilized, however, a decrease in the hole diameter and hole spacing may increase the pressure differential across the tube, thereby raising the velocity of the inert gas jets. Also, a decreased hole spacing obviously increases the cost of manufacturing the reactor tube. A hole diameter of between .51 mm to 5.1 mm should generally be satisfactory, with the uniform hole spacing of between 1.3 mm to 12.7 mm. A hole size/hole spacing chart is listed below:

| Hole diameter mm | Hole spacing mm | Comments |
|---|---|---|
| .51—.89 | 1.52—3.81 | No reactant deposition on tube under various operating conditions. |
| 1.3—1.78 | 3.05—6.35 | No reactant deposition on tube under many operating conditions. |
| 2.03—2.54 | 4.57—8.89 | Little or no reactant deposition on tube under more controlled operating conditions. |
| 3.05—5.1 | 7.62—11.43 | Probable upper limit for acceptable performance under conventional industrial operating conditions. |

From the above, it should be apparent that a reduced hole size and spacing is generally preferred, with machining costs being the primary motive for increased hole spacings. Also, the larger hole sizes and hole spacings may be more acceptable in perforated tube sections downstream from the feedstock input to the reaction zone.

It may also be desirable to provide a cylindrical tube section 20B which is unperforated. Tube sections can be drilled and section ends either sealingly glued or machined to be fitted to unperforated tube sections, so that inert gas can pass into the interior of the tube only through the perforations provided. The inert gas forms a fluid wall between the reaction zone and the interior wall of the tube 20. A representative interface between the inert gas and the reaction zone is shown in Figure 1 by the dashed lines 28.

Referring now to Figure 4, there is depicted a cross-section through a portion of a perforated tube provided with holes formed in a rectangular pattern. A tube wall having a wall thickness T of 6 mm has an exterior surface 82 and an interior surface 84. Circular perforations 90 having a diameter D of .76 mm. are provided through the tube at a hole to hole center line spacing S of 2.54 mm.

Inert gas flows through the perforations 90 and achieves fairly uniform flow within the perforations because of the D/T ratio. An inert gas jet 86 is formed commencing from the end of the opening 90, with the center line of adjacent lower gas jets being designated as 86A—86E. The boundary layer 88 of each jet expands outwardly from the center line as the jet progresses from the interior surface 84, and thus each jet may be described as having a substantially conical configuration with the sidewalls of the cones (or the sidewalls of the jets) intersecting at some distance from the interior surface 84. After the jets intersect, a uniform fluid wall is thereafter established, and the jet velocity will continue to decrease as the jet moves further from the interior surface 84.

Within the boundaries of a singular jetstream, the velocity of the gas at any point remains substantially constant, in both magnitude and direction, and there is no mixing of the gases within the jetstream on a macroscopic scale. Once the jetstreams shown in Figure 4 intersect, however, additional mixing or turbulence may occur, which further explains the difficulty in determining whether the jetstream is laminar or tubulent after jetstreams have intersected. In any event, the hole spacings are believed to be critical to the success of the present invention, and it is believed that the jetstreams maintain sufficient momentum at the point of intersection to form a uniform boundary layer sufficient to repel reactant particles.

Inert gas injected above jet 86 as well as the downward flow of the reactants within the reaction zone in the interior of reactor tube 20 create a cross-flow generally perpendicular to the initial flow of jet 86 (the cross-flow direction being axial with respect to the reactor tube 20). The center line 86A of jet 86 is therefore directed downwardly as shown in Figure 4 as the jet moves further from the interior wall 84, with the rate of downward change in the direction of jet 86 increasing as the radially-directed velocity of the jetstream is reduced and the jet is increasingly affected by the cross-flow. Since the actual pattern of the jetstreams is not known, the jet center line representations shown in Figure 4 should be understood to merely illustrate the functional concepts described herein.

The gas streams should cooperate to repel reactant particles from engaging the inner wall 84 of the tube 20, and it is believed that this repulsion is made possible because each jet maintains a sufficient radially-directed momentum to repel reactant particles at least until the jetstream overlaps with other jetstreams. Once jetstreams having such momentum overlap, an effective continuous fluid wall is created. Thereafter, the radially-directed velocity of the jets will decrease and the inert gas ultimately will flow in an axial direction having no substantial radial component, as shown in Figure 4. It is also believed that the success of the present invention, in part, is due to the fact that the gas jets lose substantially all their radially directed velocity outside of the reaction zone. In other words, inert gas at or near the interface 28 with the reaction zone is not moving radially with respect to the center line of the tube 20, and therefore does not penetrate the reaction zone interiorly of interface 28 to disturb the fluid flow within the reaction zone. Also, it is believed that reactant gas flow within the reactor zone is substantially laminar, at least after a distance of several feet downstream from the feedstock injection, which enables the axially-moving inert gas to continue to act as an effective fluid wall downstream of the perforations.

It should be apparent from the foregoing discussion that the various phenomenon contributing to the ability of the perforated tube of the present invention to successfully maintain a fluid wall sufficient to prevent reactants from contacting the inner surface of the tube is not fully understood. Theoretical gas dynamics concepts such as viscosity, laminar flow, and gas density and momentum are, of course, significantly altered by high temperatures. Also, empirical data is very difficult to obtain because of the elevated reaction temperatures previously discussed. The perforated tube described above achieves surprising and unexpected results, especially relating to its ability to form and maintain a fluid wall, and the above explanation for its success is presently believed to be valid.

Figure 4 also illustrates perforation 92 having a larger diameter at the exterior wall 82. This increased diameter area 94 may be utilized to reduce frictional fluid losses at the entrance to perforation 92, and may also be desirable from a hole manufacturing standpoint if the wall thickness T exceeds 7.6 mm. The entrance of perforation 92 may also be cone-shaped or rounded to further reduce frictional entrance losses and/or turbulence.

Figure 4 also depicts downwardly angled cylindrical perforation 96. The axis of perforation 96, if extended, would intersect or pass closely to the center line 76 to tube 20, and in that respect perforation 96 is similar to perforations 90 or 92. The axis of cylindrical perforation 96 is projected downwardly (toward the fluid exit of tube 20) so that a jet commencing from perforation 96 is initially imparted with an axially directed velocity in the direction of the ultimate inert gas flow. This inclined jet concept has not been adequately tested to determine its effect, although it is believed that a plurality of downwardly injected jets may decrease turbulence within the tube and more readily enable the generation of an axially moving laminar fluid wall. It is also believed, however, that such downwardly inclined jets may have a detrimental influence on the ability of the jets to repel reactants, due to the reduction in the radially-directed momentum of the jetstreams. A preferred range of angles, if any, for the downwardly projected jets 96 therefore has yet to be determined.

It has sometimes been observed that when the reactor is operating under conditions such that some reactive products contact the interior of the core (which condition would likely occur according to the teachings of the present invention only under abnormal operating conditions), vertical "paths", substantially corresponding to the width of the holes appear on the inner surface of the reactor tube 20 below each perforation. It has also been observed that this "path" area below each hole may extend substantially beyond the spacing of the lower row of holes. This "path" effect is believed to be due to increased nitrogen flow over that portion of the tube surface, which, in turn, may be due to the "wake" effect of the jet. In any event, this "path" is believed to be desirable especially under abnormal operating conditions, since interior surface tube material in this path remains substantially in its virgin state, while material between such paths experience a slight amount of degregation (microscopic builddown) over an extended period of time. An advantage of the spiral configuration of the holes 80 shown in Figure 3 is that the spiral offset allows the "path" inner tube surfaces to overlap, thus effectively obtaining a totally virgin-state inner surface of the tube rather than obtaining a "paths" along the vertical column 79B. In other words, an advantage of the spiral arrangement of the holes 80 as shown in Figure 3 is that the "path" below hole 80A may extend vertically downward five or more rows past hole 80F, and the elongate path under each of the holes thus overlaps to effectively provide a "virgin state" inner tube surface. Thus, it should be understood that regardless of the particular hole arrangement, an effective fluid wall should be formed according to the present invention to keep reactant products from contacting the tube interior wall under normal reactor operating conditions. Because of this "path" effect, the spiral hole arrangement may have advantages to minimize tube deterioration under abnormal operating conditions.

As previously noted, extended life of the perforated reactor tube compared to porous tubes is a significant feature of the present invention, and the drilled tube should be able to structurally withstand compressive forces on the tube when operating at high temperature for extended periods of time. It has been determined that the entrance openings for the perforations may tend to increase with a conical configuration as the tube life increases. This conical increase or erosion of the entrance areas of the perforations is generally symmetrical with respect to the center line of each perforation, and after a relatively long period of time, the erosion of the outer wall adjacent the opening of each hole effectively decreases the compressive strength of the tube, the tube strength being effectively determined by the strength of the "columns" of core material between the columns of holes.

These tube material columns are spaced between corresponding holes are thus truly vertical for a square or rectangular hole pattern, but would be spiralled for the hole pattern of holes 80. Since a strictly vertical column can support much more weight before failing than columns spiralling about a center line, a square or rectangular lattice pattern is preferably over the arrangement of the holes 80 to minimize the likelihood of tube structural failure over a long operating period.

A triangular hole pattern offers increased "cleaned path" surfaces compared to a square hole pattern, while still retaining narrower vertical outer wall columns between holes. A hexagonal or outer hole pattern may also be used, depending on the desired tradeoff between reactor tube strength and the efficiency of the hole pattern in forming and maintaining a fluid wall.

As indicated above, it may be desirable to include both a solid (non-porous) and unperforated section of the tube within the reaction zone. A perforated section of the tube may be essential in the vicinity where the feedstock is input into the reactor. At this input location, individual particles of reactant material and reaction-created gas molecules may have a substantial radial as well as axial velocity, due to the intensity of the chemical reactions and the creation of new reaction gases. This supposedly turbulent condition results in reaction particles in the range of up to approximately 0.5 mm being thrust with a radially-directed velocity toward the reactor tube, and these particles are repelled from contacting the inner surface of the reactor tube by the opposing radially-directed momentum of the overlapping jets.

Several feet downstream from the feed material injection locations, however, the individual reactor particles and reaction gas molecules within the reaction zone will necessarily have achieved substantially axially movement with respect to the tube. It has been determined that although radially-directed inert gas jets may be necessary in the region adjacent the feed input, the injected inert gas flowing downstream continues to maintain a fluid wall blanket. This axially moving fluid wall creates a sufficient barrier to prohibit the inner axially moving reaction gases and reactant particles from coming into engagement with an unperforated tube wall section. Moreover, this axially moving inert gas can create an effective fluid wall under these conditions over a distance of at least several feet. The flow of the inert gas downstream of the jets and the flow of reaction gases at this location are thus considered laminar.

Figure 5 illustrates a simplified cross-sectional view of a reactor chamber including a modified reactor tube. (In both Figures 5 and 6, the holes shown are intended simply to illustrate a perforated tube, and the hole spacings are not in proper proportion to the reactor tube). The reactor includes the cylindrical housing 16 for the heating elements 18, as previously discussed. The feed tube 22 terminates within the upper housing 53, and the lower housing 54 provides a transition to the downstream equipment. The reactor tube shown in Figure 5 comprises three separate reactor tube sections: a perforated tube section 102 extending from the top of the tube until about the middle of the housing 16, a solid and unperforated tube section 104 extending from tube 102 to position adjacent the lower end of the large cylindrical housing 16, and a perforated tube section 106 extending from the tube 104 to the lower end of the reactor tube. Each of these tube sections is axially aligned and may be sealingly joined by conventional means.

Inert gas may be injected through one or more of the ports 110 for passing inert gas through the perforations in section 102 to form the desired fluid wall comprising a plurality of radially projecting jets in the vicinity of the feedstock input. By the time the feed material and reactor gases reach the middle of the housing 16, the reactor material and gases within the reaction zone should be moving substantially axially with respect to the axis of the tube. An unperforated tube section 104 of several feet or more in length may thus be provided, with the fluid wall being maintained by the laminar axially moving inert gas flow, as described above. Within cylinder 54 adjacent the exit of the reactor section, turbulence within the reactor tube may be increasing, and the fluid wall may begin to break-down. Accordingly, another perforated section of reactor tube 106 is provided to insure that the reactant particles do not come into engagement with the lower end of the reaction tube.

It has been further observed that material may eventually accumulate on the outer surface of the reactor tube as the reactor is operated over a long period of time, especially in a relatively cooler zones of the reaction chamber. It is believed that this buildup of material is at least partially caused by condensation of carbon or graphite vapors formed outside of the reactor tube in the hot zone adjacent the heating elements. This vapor cools and condenses when entering a cooler zone, and may thus build up on the outside of the reactor tube, thereby possibly plugging some of the perforated holes. Accordingly, it may be necessary to periodically clean the outer wall of the perforated sections of the reactor tube to remove this buildup.

To reduce the above buildup on the outside of the reactor tube, inert gas may be input into the reactor only in the vicinity of the perforated tube sections. To further reduce or eliminate the buildup, inert gas may be input into a chamber in fluid communication with the perforations in a perforated section of the tube, but sealed from the adjacent unperforated sections of the tube. An unperforated section of the tube is preferably provided in a hot zone, since this is the zone which would otherwise most likely experience tube failure due to the extended temperatures and corrosion of the outer wall. Accordingly, it may be desirable under certain conditions to inject inert gas only in the vicinity of the cool perforated tube sections, or to isolate the exterior of the unperforated hot-zone tube section from the exterior of the perforated cool-zone tube section, thereby reducing the buildup on the outside of the perforated tube section.

Referring again to Figure 5, inert gas may thus be injected through ports 110 in housings 53 and 54, while port 110 in housing 16 is sealed. The closing of port 110 in housing 16 should reduce the buildup on the outside of perforated tube sections 102 and 106, since the injected gas need not pass by the elements 18 before entering the perforations in the tube.

Referring to Figure 6, another reactor is shown, with a reactor tube comprising alternating perforated and unperforated sections 114, 116, 118, 120, 122, and 123. Each of the perforated sections is sealed outwardly from the unperforated sections by graphite packing rings 125 and/or other horizontal barrier layers. Thus, the perforated section 114 is sealed from the chamber outside of the unperforated section 116 containing the heating elements 18. Similarly, perforated section 118 is sealed from adjacent unperforated sections by horizontal barriers 128 and 130. Each of the perforated sections shown in Figure 6 is provided with its own inert gas input 110. Accordingly, inert gas entering the reactor tube need not be in fluid communication with the hot portion outside the unperforated section of the tube adjacent the heating elements 18. As previously indicated, the fluid dynamics of the inert gas will largely depend on the gas temperature. In the embodiment shown in Figure 6, the inert gas may not be as hot as the gas passing through the tube of the embodiment shown in Figure 5. In order to maintain the desired inert gas characteristics, the inert gas provided to the perforated sections of the tube shown in Figure 6 may be preheated by conventional means.

Figure 6 illustrates that a short perforated tube section 118 may be provided between an otherwise elongate hot zone. Laminar flow of inert gas within the unperforated section 116 may begin to break down, and perforated tube section 118 is provided to reestablish a strong fluid wall and again commence uniform laminar flow of the inert gas adjacent the interior of the unperforated section 120. Figure 6 also illustrates that unperforated sections of the reactor tube may be provided in the area generally adjacent the heating elements, while perforated tube sections are provided in the relatively cool reactor zones. Finally, restricting the flow of inert gas from the heating elements 18 as shown in Figure 6 may extend the life of the heating elements, although additional life from the elements 18 may also be obtained by using another inert gas, such as argon.

To further maximize the efficiency of the fluid wall formed within the perforated reactor tube, it may be desirable to provide perforated tube sections wherein the hole size, hole spacing, and hole orientation vary depending upon the intended placement of the tube section relative to the feedstock input location and the heating and cooling zones. As an example, perforations in sections 118 and 122 may be angled downwardly, as previously described, to achieve a uniform downstream laminar fluid wall without generating a strictly radially-directed pattern of jets, since fluid gas and reactants entering these zones should be moving substantially in the axial direction. Similarly, it may be possible to increase the hole spacing in sections 118 and 122 or reduce the gas flow rate per unit area for these tube sections compared with the hole spacing and gas flow rate used for section 114. It may be feasible to replace unperforated tube sections with sections having large diameter perforations at very large spacings, and to substantially reduce the gas flow per unit area to such a tube section. The gas passing through such large perforations may act primarily to enhance uniform laminar flow, and overlapping of gas jets having a substantially radially-directed momentum would not be obtained.

It should be apparent that the embodiments herein described achieve numerous advantages over reactors utilizing porous tubes as described in the US—A—4 044 117. The perforated tube allows for a much stronger fluid wall to repel reactants than was obtained using the porous tube. The perforated tube of the present invention requires much less inert gas than the porous tube, thus both reducing reactor operating costs and allowing the downsizing of gas purification equipment. The increased thermal conductivity of the reactor tube compared to porous reactor tube results in a higher reaction temperature and therefore increases the reactor efficiency. Compared to porous reactor tubes, the perforated reactor tube of the present invention has a relatively high resistance to chemical attack due to its non-porous nature, and is much stronger than a porous reactor tube, as previously explained. It is therefore believed that the perforated tube may typically have a reactor life of at least fifty times the life of a porous tube.

The present invention thus makes feasible the commercial operation of a reactor utilizing a perforated tube diameter of from .36 to 1.52 m. Such a reactor may, for example, be used to commercially produce carbon black, to gasify coal by pyrolysis, to decompose hazardous waste materials, to thermally crack petroleum products, or to reduce oxides of inorganic compounds in the presence of hydrogen. Numerous other possible uses for the high temperature fluid wall reactor are disclosed in the US—A—4 044 117 which are incorporated herein by reference.

In another embodiment of the invention, .70 mm diameter holes are provided in a drilled section of a 324 mm ID, 354 mm OD core, at 2.54 mm hole spacings. A 13 foot (4.0 m) long cylindrical core has at least .91 m, and preferably at least 1.2 m, of total drilled core sections, with approximately 1.8 m of the core heated directly and an additional .6 to 1.2 m heated by radiation spillage. In order to produce an effective inert gas blanket, the holes are preferably drilled perpendicular to the core axis, rather than at an inclined angle. Two .61 m sections of drilled core, each at least substantially in or adjacent the "cool" zone of the reactor, are separated by a 1.82 m solid core section in the hot zone. The drilled core sections may be isolated from the electrodes in the manner as shown in Figure 6.

In the above embodiment, a PRTZ section approximately 1.5 m diameter and 6.1 m long may be utilized. This post reactor treatment section need not necessarily be insulated. The PRTZ section may be cooled on the outside, irrespective of whether insulating material (e.g., insulating brick) is or is not utilized. Alternatively, the PRTZ section may be cooled by a simple water-cooled tank internal to the shell, as previously described, and again insulating material may or may not be utilized depending on the desired reaction and preferred temperature gradient within the PRTZ section.

The above-described reactor core may be used in the destruction of soil contaminated with harzardous waste. Between .09 to .33 scmm and preferably between .13 to .27 scmm of nitrogen per .093 square meters of drilled core area is utilized to form an effective blanket. Injection of inert gas rates greater than that necessary to form a blanket may cause increased turbulence in the core and therefore decrease core life and reactor efficiency. In order to minimize hole plugging on the outside of the drilled core sections and to provide an effective blanket of inert gas, nitrogen is preferably heated to at least 427°C. Preferably a high purity inert gas is utilized to decrease core degradation; nitrogen with less than 1 part per million oxygen and water may be produced by conventional equipment, or may be commercially purchased. Excess hydrogen in the nitrogen may decrease core life, especially if the drilled core sections are positioned in the hot section of the reactor. A relatively "tight" soil column in the reactor may be obtained inputting as much as 640 kg of soil per minute into the reactor (freefalling), and injecting approximately 5.7 scmh of nitrogen in the feed tube area to stabilize soil flow. The injection of a low-volume nitrogen gas with the feed material results in the velocity of the gas about the feed material approximating the feed material velocity, thereby reducing aspirating gases and decreasing turbulences. Injection of too much gas in the feed tube area may tend to blast soil particles toward the reactor wall, and may therefore be dangerous to core life and/or decrease the effectiveness of the desired reaction within the core.

Even though the nitrogen may be preheated to 800°F or more, placement of the drilled core sections in the relatively "cool" zone of the reactor may substantially decrease the ability to form an effective blanket. It should therefore be understood that, depending on the nature of the chemical reaction intended, it may nevertheless be beneficial to place the drilled core sections in the "hot" zones of the reactor adjacent the cool zones, rather than in the cool zones themselves. Although this modification may increase core degradation, the benefit of a more effective blanket of inert gas may be obtained. Also, it is believed that the maximum practical length of solid core section (no drilled holes) may be approximately 1.8 m while still maintaining an effective blanket of inert gas, and accordingly, placement of the drilled core sections toward but not in the cool zones may decrease the need for any drilled core sections toward the middle of the hot zone.

It should be understood that modifications to any reactor described herein may be necessary depending on the intended reaction. For example, in some reactors, a "tight" input material column may not be desirable from the standpoint of the reaction efficiency, but generally may be desirable from the standpoint of core life. A trade-off of relevant considerations will thus be necessary. It is believed, however, that the central concepts described herein relating to the formation of a drilled core reactor and the injection of an inert gas with a radially directed momentum sufficient to repel reaction particles in the vicinity of the drilled core, followed by laminar flow of inert gas in an axial direction to maintain an effective fluid wall, remain valid concepts for the apparatus and methods of the present invention.

It is also within the concept of the present invention to utilize inductive heating rather than resistance heating. Thus, the electrodes described herein could be replaced with inductive heaters, which would similarly radiate energy to the reactor tube, which in turn would radiate the reaction zone to sustain the desired chemical reaction. Large inductive heaters are commercially available, so that the commercial scale-up of such a reactor is feasible. The use of inductive heaters compared to resistance heaters may also increase the heat transfer efficiency to the feedstock, and may eliminate some difficulties associated with the use of resistance electrodes operating within high temperatures environments.

The reactor tube of the present invention is thus particularly useful for a high-temperature fluid wall reactor wherein the reaction zone spaced within the interior of the tube is substantially heated by radiant energy. In many instances, this radiant energy is absorbed by the reactant itself, which raises the temperature within the reaction zone so that reaction gases within the reaction zone (having a relatively low radiation absorption coefficient) are heated by both convention and radiation. The US—A—4 044 117 teaches that if the reactant itself does not exhibit a high radiation absorption rate, a "target material" may be added to the reaction zone to raise the temperature in the reaction zone. The tube of the present invention is well suited for radiation coupling type reactors, wherein radiation heaters radiate a tube which in turn radiates a radially inward reaction zone. Alternatively, a tube material having a very low radiation absorption coefficient may be used, so that radiation from heaters passes through the tube, and the reaction zone is thus radiantly heated directly by the heaters exterior to the tube.

Any number of high quality graphite materials may be used for the core. Suitable core materials are Stackpole 2020 or Stackpole 2191, each a fine grain graphite material commercially available from Stackpole Corporation in St. Marys, Pennsylvania. This core material may be purified by a vacuum of gasing, or "F" purifying processes, both standard techniques in graphite technology, which reduce impurities in the material and increase core life. Vacuum out gasing may typically reduce iron content in the drilled core from 600 to 50 parts per million, and similarly reduce calcium from 200 to 20 parts per million and silicon from 300 to 30 parts per million. Another carbon/carbon composition material is available from Carbon Carbon Advance Technologies, Inc. in Fort Worth, Texas. This material, made from mats of graphite cloth impregnated with carbon resin which is then graphitized is stronger than Stackpole 2020, and should therefore experience less degradation and have a longer life.

The use of high quality graphite core materials, coupled with commercially available graphite purification techniques and due care to minimize reactor leaks, substantially reduces core degradation and therefore increases core life. Due to substantially increased thermal conductivity over porous core materials, as previously mentioned, a 2.5 cm core wall thickness may be utilized with the above high quality materials and purification techniques to obtain substantially increased core life. Also, this higher quality, stronger, and thicker core material may withstand higher maximum pressure differentials, in the range of from 25.2 to 37.9 gm./sq. cm of water. For the embodiment described above, increases in pressure above this range result from substantial hole plugging, and thus the decreasing effectiveness of the blanket and/or the possiblity of core collapse necessitate cleaning.

Since the above techniques substantially reduce core degradation, the benefits of long cleaned "paths" on the inner surface of the core are minimized, and accordingly the advantages using a spiral "offset" drilled hole arrangement are not as significant, although this arrangement is still generally preferable. These techniques have not, however, also reduced the likelihood of drilled hole plugging either on the outside surface of the drilled core (if positioned in the cool zone), or on the inside of the drill core (if positioned in the hot zone). This hole plugging is believed to be attributable to condensation of vaporized electrode material on the somewhat "cooler" care surface. As holes plug, the pressure differential may increase to the range previously noted and, if the differential rises above that range, the reactor may have to be shut down and the core cleaned. Minimizing such hole plugging may be obtained by isolating the drilled holes from gases in fluid communication with the electrodes (although an effective blanket must still be maintained), by using higher quality electrodes with less impurities to decrease vaporization, or by increasing electrode surface areas to decrease heat flux through the electrode cross-section. Electrodes fabricated from and purified by the techniques described above with respect to cores may therefore minimize hole plugging.

The reactor tube may be fabricated from graphite, as described above, although many other refractory materials may be used. Examples of other suitable reactor tube materials include carbon, silicon carbide, boron nitride, and silicon nitride. The reactor tube material may in turn determine the preferred technique for perforating the tube. Conventional rotary drilling has been utilized for graphite tubes, although both ultrasonic drilling and laser drilling have also been successfully employed. If laser drilling is employed, perforations may be frusto-conically shaped rather than cylindrical, but this should not detract from the ability of the perforated tube to generate a protective fluid wall. Various gases other than nitrogen and argon may be used. The selected inert fluid should be substantially transparent to radiation, and should also be substantially inert with respect to the reactor tube material at various temperatures. Other suitable inert gases include hydrogen, helium, and xenon.

With regard to the feedstock material for forming the fiber material of the present invention, several formulations have also been successful. These include differing types of inorganic material such as sand, ground glass, soil, and zircon as a source of silicon, and differing types of oil and carbon blacks, halogenated organics, and propane as a source of carbon to enhance the reaction.

It is therefore apparent that the present invention is one well adapted to obtain all of the advantages and features hereinabove set forth, together with other advantages which will become obvious and apparent from a description of the invention itself. It will be understood that certain combinations and subcombinations are of utility and may be employed without reference to other features and subcombinations. Moreover, the foregoing disclosure and description of the invention is only illustrative and explanatory thereof, and the invention admits of variations in the size, shape and composition of the material, as well as in the details of the illustrated construction and process, without departing from the scope and spirit thereof.

**Claims**

1. In a high-temperature fluid-wall reactor including a cylindrical-shaped reactor tube (20) having a central axis (76) and formed from a refractory material, a reaction zone (29) within said reactor tube (20) for inputting reactants, means (18) for heating said reaction tube (20) to incandescence for emitting radiation radially inward to said reaction zone (29) for maintaining a desired chemical reaction, and inlet means (24) through a housing (16) of the reactor (10) for inputting an inert gas to the reactor (10) for forming a protective fluid wall for the inner surface (84) of said reactor tube (20), characterized

in that said reactor tube material is substantially impervious to gas flow,

in that said reactor tube (20) has a plurality of perforations (90) for permitting flow of said inert gas radially inward through said tube (20),

in that each of said plurality of perforations (90) includes an exit adjacent said inner wall (84) of said reactor tube (20) for directing said inert gas in a jetstream (86) commencing adjacent said exit and directed toward said reaction zone (29),

in that said plurality of perforations (90) are spaced about said reactor tube (20) such that each of said jetstreams (86) engages one or more other of said jetstreams for forming an integral protective fluid wall while maintaining a radially directed momentum sufficient to repel said reactants, and

in that the radially directed velocity of each of said jetstreams diminishes within said reactor tube (20) without disturbing fluid flow within said reaction zone (29).

2. The apparatus according to claim 1, wherein each of said plurality of perforations (90) through said reactor tube (20) is formed about an aperture axis passing substantially through said central axis (76) of said reactor tube (20).

3. The apparatus according to claim 1, further comprising:

a first cylindrical-shaped reactor tube section (118) having said perforations (90) spaced substantially throughout the length of said first tube section (118) and spaced substantially around the perimeter of said first tube section (114), and

a second cylindrical-shaped reactor tube section (120) spaced downstream of said first tube portion and being substantially unperforated,

said inert gas flow downstream of said first tube section (118) being substantially laminar for maintaining said protective fluid wall throughout the length of said second tube section (120).

4. The apparatus according to claim 2, wherein each of said perforations (90) through said reactor tube (20) has a generally cylindrical configuration formed about said aperture axis and a diameter of about 0.51 mm or greater.

5. The apparatus according to claim 2, wherein said aperture axis of each of said perforations (90) is substantially perpendicular to said central axis (76) of said reactor tube (20).

6. The apparatus according to claim 2, wherein said plurality of perforations (90) are located about said reactor tube (20) such that any line of an inner surface (84) of said reactor tube (20) passes through a plurality of said perforations (90).

7. The apparatus according to claim 6, wherein said plurality of perforations (90) are located on said reactor tube (20) at lattice points of the uniform lattice pattern.

8. The apparatus according to claim 1, wherein said reactor tube material has a thermal conductivity in a radial direction with respect to said central axis of at least 27.7 watts/meter°C at 2200°L.

9. The apparatus according to claim 4, further comprising:

conduit means (110) for passing inert gas to the exterior surface of said first cylindrical tube section (118), and

barrier means (130) for restricting inert gas flow from said exterior surface of said first cylindrical tube section (118) to the exterior surface of said second cylindrical tube portion (120).

10. The apparatus according to claim 4, wherein said plurality of perforations (90) each have mean diameters in the range of from 0.51 mm to 2.55 mm and are spaced about said reactor tube (20) at centerline spacings of from 1.6 mm to 15.3 mm.

11. A method for forming a fluid wall in a high temperature reactor (10) of the type employing a reaction zone (29) for inputting reactants within a reactor tube (20) and heating said reactor tube (20) to incandescence for emitting radiation radially inward from said reactor tube (20) to maintain a desired chemical reaction, characterized by

forming a plurality of perforations (90) through said reactor tube (20) each having a linear perforation axis,

passing inert gas inwardly through said plurality of perforations (90) for forming inert gas jetstreams maintaining a radially-directed momentum sufficient to repel said reactants,

spacing said plurality of perforations (90) about said reactor tube (20) such that said jetstreams overlap for forming an integral protective fluid wall, and

controlling the velocity of said jetstreams such that the radially-directed velocity component of said jetstreams substantially terminates before reaching said reaction zone.

12. The method according to claim 11, wherein each of said plurality of perforations (90) through said reactor tube (20) is directed along said perforation axis passing substantially through a central axis (76) of said reactor tube (76).

13. The method according to claim 11, further comprising:

forming a first section (118) of said reactor tube (20) having said plurality of perforations (90),

spacing a second unperforated section (120) of said reactor tube (20) downstream of said first section (118), and

controlling the flow rate and temperature of said inert gas passing through said perforations (90) for obtaining laminar flow downstream from said first portion (118) of said reactor tube (20) to maintain said fluid wall within said second section (120) of said reactor tube (20).

14. The method according to claim 13, further comprising:

passing inert gas from outside said reactor (10) into engagement with a chamber at least partially defined by the outer surface of said first portion of said reactor tube (20), and

prohibiting inert gas flow from said outer surface of said first portion (118) of said reactor tube (20) to the outer surface of said second portion (120) of said reactor tube (20).

15. The method according to claim 12, wherein each of said perforations (90) is formed in a generally cylindrical configuration about said perforation axis, and wherein said perforation axis is substantially perpendicular to said central axis of said reactor tube (20).

16. The method according to claim 12, further comprising:

locating said plurality of perforations (90) about said reactor tube (20) such that any line on the inner surface of said reactor tube (20) parallel to said central axis of said reactor tube (20) passes through a plurality of said perforations (90).

17. The method according to claim 11, further comprising:

forming said plurality of perforations (90) through said reactor tube (20) each having a mean diameter in the range of from 0.51 mm to 2.55 mm, and

spacing said plurality of perforations (90) about said reactor tube at centerline spacings of from 1.6 mm to 15.3 mm.

18. The method according to claim 14, further comprising:

passing inert gas from outside said reactor (10) into engagement with a chamber at least partially defined by the outer surface of said first portion (118) of said reactor tube (20), and

heating said inert gas before being passed to said chamber defined by said outer surface of said first portion (118) of said reactor tube (20).

19. The method according to claim 18, further comprising:

providing a third perforated section (122) of said reactor tube (20) downstream from said second unperforated section (120) of said reactor tube (20), and

passing inert gas radially inward through perforations (90) in said third section (122) of said reactor tube (20) for maintaining a protective fluid wall for said third section (122) of said reactor tube (20).

20. The method according to claim 11, wherein the pressure differential across said reactor tube (20) is maintained in the range of from 1.3 to 10.1 gm/sq.cm of water when the inert gas is passed inwardly through said plurality of perforations (90).

21. The method according to claim 13, wherein the step of controlling the flow rate and the temperature of the inert gas comprises:

preheating the inert gas prior to passing the inert gas through said plurality of perforations.

22. The method according to claim 13, further comprising:

substantially isolating an exterior wall of said first section (118) of said reactor tube (20) from an exterior wall of said second section (120) of said reactor tube (20).

**Patentansprüche**

1. Hochtemperatur-Reaktor mit Fluid-Wand bzw. Strömungsmittelwand oder -vorhang, umfassend ein eine Mittelachse (76) aufweisendes und aus einem Feuerfestmaterial geformtes, zylindrisches Reaktorrohr (20), eine im Reaktorrohr (20) festgelegte Reaktionszone (29), in die Reaktionsteilnehmer einebbar sind, eine Einrichtung (18) zum Erwärmen des Reaktorrohrs (20) auf Weißglut zum radial einwärts gerichteten Emittieren von Strahlung zur Reaktionszone (29) zwecks Aufrechterhaltung einer gewünschten chemischen Reaktion sowie eine ein Gehäuse (16) des Reaktors (10) durchsetzende Einlaßeinheit (24) zum Einspeisen eines Inertgases in den Reaktor (10) zwecks Ausbildung einer (eines) schützenden Fluid-Wand bzw. Strömungsmittelwand oder -vorhangs für die Innenfläche (84) des Reaktorrohrs (20), dadurch gekennzeichnet,

daß das Reaktorrohrmaterial praktisch gasundurchlässig ist,

daß das Reaktorrohr (20) eine Vielzahl von Perforationen (90) zur Ermöglichung einer radial einwärts gerichteten Strömung des Inertgases durch das Rohr (20) aufweist,

daß jede der Vielzahl von Perforationen (90) einen Auslaß an der Innenwand(fläche) (84) des Reaktorrohrs (20) aufweist, um das Inertgas in einem am Auslaß beginnenden und zur Reaktionszone (29) gerichteten Gasstrahl (86) zu führen,

daß die zahlreichen Perforationen (90) um das Reaktorrohr (20) herum derart auf Abstände angeordnet sind, daß jeder der Gasstrahlen (86) in einen oder mehrere andere Gasstrahlen übergeht zwecks Bildung einer zusammenhängenden schützenden Strömungsmittelwand unter Aufrechterhaltung eines für das Abstoßen der Reaktionsteilnehmer ausreichenden, radial gerichteten Moments bzw. Impulses, und

daß die radial gerichtete Geschwindigkeit bzw. Radialgeschwindigkeit jedes der Gasstrahlen innerhalb des Reaktorrohrs (20) abnimmt, ohne eine Strömungsmittelströmung in der Reaktionszone (29) zu stören.

2. Reaktor nach Anspruch 1, dadurch gekennzeichnet, daß jede der zahlreichen, das Reaktorrohr (20) durchsetzenden Perforationen (90) um eine Öffnungsachse ausgebildet ist, die praktisch durch die Mittelachse (76) des Reaktorrohrs (20) verläuft bzw. diese schneidet.

3. Reaktor nach Anspruch 1, gekennzeichnet durch

einen ersten zylindrischen Reaktorrohrabschnitt (118), bei dem die Perforationen (90) im wesentlichen über die Gesamtlänge und im wesentlichen um den Umfang des ersten Reaktorrohrabschnitts (118) herum auf Abstände verteilt sind, und

einen zweiten, dem ersten Rohrabschnitt nachgeschalteten und praktisch unperforierten zylindrischen Reaktorrohrabschnitt (120),

wobei der Inertgasstrom stromab des ersten Rohrabschnitts (118) im wesentlichen laminar ist, um die schützende Strömungsmittelwand über die Länge des zweiten Rohrabschnitts (120) hinweg aufrechtzuerhalten.

4. Reaktor nach Anspruch 2, dadurch gekennzeichnet, daß jeder der das Reaktorrohr (20) durchsetzenden Perforationen (90) eine im wesentlichen zylindrische, um die Öffnungsachse herum gebildete Form aufweist und einen Durchmesser von etwa 0,51 mm oder mehr besitzt.

5. Reaktor nach Anspruch 2, dadurch gekennzeichnet, daß die Öffnungsachse jeder der Perforationen (90) im wesentlichen senkrecht zur Mittelachse (76) des Reaktorrohrs (20) liegt.

6. Reaktor nach Anspruch 2, dadurch gekennzeichnet, daß die zahlreichen Perforationen (90) um das Reaktorrohr (20) herum so angeordnet sind, daß eine beliebige Linie einer Innenfläche (84) des Reaktorrohrs (20) durch eine Vielzahl der Perforationen (90) verläuft.

7. Reaktor nach Anspruch 6, dadurch gekennzeichnet, daß die zahlreichen Perforationen (90) am Reaktorrohr (20) auf Gitterpunkten eines gleichförmigen Gittermusters liegen.

# EP 0 176 770 B1

8. Reaktor nach Anspruch 1, dadurch gekennzeichnet, daß das Reaktorrohrmaterial eine Wärmeleitfähigkeit in Radialrichtung zur Mittelachse von mindestens 27,7 W/m/°C bei 2200°C aufweist.

9. Reaktor nach Anspruch 4, gekennzeichnet durch

eine Leitungseinheit (110) zum Führen von Inertgas zur Außenfläche des ersten zylindrischen Rohrabschnitts (118) und

eine Sperren- oder Schrankeneinheit (130) zum Begrenzen einer Inertgasströmung von der Außenfläche des ersten zylindrischen Rohrabschnitts (118) zur Außenfläche des zweiten zylindrischen Rohrabschnitts (120).

10. Reaktor nach Anspruch 4, dadurch gekennzeichnet, daß die zahlreichen Perforationen (90) jeweils einen mittleren Durchmesser im Bereich von 0,51—2,55 mm aufweisen und um das Reaktorrohr (20) herum mit Mittel(linien)abständen von 1,6—15,3 mm auf Abstände verteilt sind.

11. Verfahren zur Ausbildung einer Fluid- oder Strömungsmittelwand in einem Hochtemperatur-Reaktor (10) mit einer Reaktionszone (29) zum Einbringen von Reaktionsteilnehmern in ein Reaktorrohr (20) und zum Erwärmen des Reaktorrohrs (20) auf Weißglut zwecks radial einwärts gerichteter Emission von Strahlung vom Reaktorrohr (20), um eine gewünschte chemische Reaktion aufrechtzuerhalten, dadurch gekennzeichnet, daß

eine Vielzahl von Perforationen (90) mit jeweils einer geradlinigen Perforations- oder Öffnungsachse durch das Reaktorrohr (20) hindurch ausgebildet werden,

durch die zahlreichen Perforationen (90) ein Inertgas radial einwärts geleitet wird, um Inertgasströme unter Aufrechterhaltung eines radial gerichteten Moments oder Impulses, das bzw. der zum Abstoßen der Reaktionsteilnehmer ausreicht, zu erzeugen,

die zahlreichen Perforationen (90) um das Reaktorrohr (20) herum auf solche Abstände verteilt werden, daß die Gasströme einander unter Ausbildung einer zusammenhängenden Fluid- oder Strömungsmittelwand überlappen, und

die Geschwindigkeit der Gasströme so kontrolliert bzw. geregelt wird, daß die radial gerichtete Geschwindigkeitskomponente der Gasstrahlen praktisch vor Erreichen der Reaktionszone endet.

12. Verfahren nach Anspruch 11, dadurch gekennzeichnet, daß jede der Vielzahl von Perforationen (90) durch das Reaktorrohr (20) längs der Öffnungsachse gerichtet ist, die im wesentlichen durch eine Mittelachse (76) des Reaktorrohrs (20) verläuft bzw. diese schneidet.

13. Verfahren nach Anspruch 11, dadurch gekennzeichnet, daß

ein erster Abschnitt (118) des Reaktorrohrs (20) mit der Vielzahl von Perforationen (90) geformt wird,

ein zweiter, unperforierter Abschnitt (120) des Reaktorrohrs (20) stromab des ersten Abschnitts (118) bzw. diesem nachgeschaltet angeordnet wird und Strömungsmenge oder -geschwindigkeit und Temperatur des die Perforationen (90) durchströmenden Inertgases geregelt werden, um stromab des ersten Abschnitts (118) des Reaktorrohrs (20) eine Laminarströmung für die Aufrechterhaltung der Strömungsmittelwand im zweiten Abschnitt (120) des Reaktorrohrs (20) herbeizuführen.

14. Verfahren nach Anspruch 13, dadurch gekennzeichnet, daß

Inertgas von der Außenseite des Reaktors (10) in eine Kammer eingeführt wird, die zumindest teilweise durch die Außenfläche des ersten Abschnitts des Reaktorrohrs (20) festgelegt ist, und

eine Inertgasströmung von der Außenfläche des ersten Abschnitts (118) des Reaktorrohrs (20) zur Außenfläche des zweiten Abschnitts (120) des Reaktorrohrs (20) verhindert oder unterbunden wird.

15. Verfahren nach Anspruch 12, dadurch gekennzeichnet, daß jede der Perforationen (90) mit einer im wesentlichen zylindrischen Form um die Perforations- oder Öffnungsachse herum geformt wird und die Öffnungsachse im wesentlichen senkrecht zur Mittelachse des Reaktorrohrs (20) liegt.

16. Verfahren nach Anspruch 12, dadurch gekennzeichnet, daß

die zahlreichen Perforationen (90) um das Reaktorrohr (20) herum so angeordnet werden, daß eine beliebige Linie auf der Innenfläche des Reaktorrohrs (20), die parallel zur Mittelachse des Reaktorrohrs (20) verläuft, durch eine Anzahl der Perforationen (90) hindurchgeht.

17. Verfahren nach Anspruch 11, dadurch gekennzeichnet, daß

die zahlreichen Perforationen (90) durch das Reaktorrohr (20) mit jeweils einem mittleren Durchmesser im Bereich von 0,51—2,55 mm ausgebildet werden und die zahlreichen Perforationen (90) mit Mittel(linien)abständen von 1,6—15,3 mm um das Reaktorrohr herum auf Abstände verteilt werden.

18. Verfahren nach Anspruch 14, dadurch gekennzeichnet, daß

Inertgas von der Außenseite des Reaktors (10) in eine Kammer eingeführt wird, die zumindest teilweise durch die Außenfläche des ersten Abschnitts (118) des Reaktorrohrs (20) festgelegt ist, und

das Inertgas vor der Einführung in die durch die Außenfläche des ersten Abschnitts (118) des Reaktorrohrs (20) festgelegte Kammer erwärmt wird.

19. Verfahren nach Anspruch 18, dadurch gekennzeichnet, daß

ein perforierter dritter Abschnitt (122) des Reaktorrohrs (20) stromab des unperforierten zweiten Abschnitts (120) des Reaktorrohrs (20) vorgesehen wird und

Inertgas radial einwärts durch Perforationen (90) im dritten Abschnitt (122) des Reaktorrohrs (20) geleitet wird, um eine schützende Strömungsmittelwand für den dritten Abschnitt (122) des Reaktorrohrs (20) aufrechtzuerhalten.

20. Verfahren nach Anspruch 11, dadurch gekennzeichnet, daß die Druckdifferenz über das Reaktorrohr (20) im Bereich von 1,3—10,1 g/cm² Wassersäule gehalten wird, wenn das Inertgas durch die zahlreichen Perforationen (90) einwärts geleitet wird.

21. Verfahren nach Anspruch 13, bei dem der Schritt der Regelung von Strömungsmenge oder -geschwindigkeit und Temperatur des Inertgases umfaßt:

Vorwärmen des Inertgases vor dem Leiten des Inertgases durch die Vielzahl von Perforationen.

22. Verfahren nach Anspruch 13, dadurch gekennzeichnet, daß

eine Außenwand des ersten Abschnitts (118) des Reaktorrohrs (20) praktisch von einer Außenwand des zweiten Abschnitts (120) des Reaktorrohrs (20) getrennt wird.

## Revendications

1. Dans un réacteur à paroi fluide à haute température comprenant un tube de réaction (20) de forme cylindrique, possédant un axe central (76) et réalisé en matériau réfractaire, une zone de réaction (29) à l'intérieur dudit tube de réaction (20) destinée à l'introduction de réactifs, des moyens (18) pour chauffer ledit tube de réaction (20) à l'incandescence pour émettre un rayonnement radialement vers l'intérieur vers ladite zone de réaction (29) pour maintenir une réaction chimique souhaitée, et des moyens d'entrée (24) à travers une enceinte (16) du réacteur (10) pour amener un gaz inerte au réacteur (10) afin de former une paroi fluide protectrice pour la surface intérieure (84) dudit tube de réaction (20), caractérisé

en ce que ladite matière de tube de réaction est sensiblement imperméable au flux gazeux,

en ce que ledit tube de réaction (20) comporte plusieurs perforations (90) pour permettre un flux dudit gaz inerte radialement vers l'intérieur à travers ledit tube (20),

en ce que chacune desdites perforations multiples (90) comprend une sortie adjacente à ladite paroi intérieure (84) dudit tube de réaction (20) pour diriger ledit gaz inerte en un écoulement en jet (86) commençant près de ladite sortie et dirigé vers ladite zone de réaction (29),

en ce que lesdites multiplex perforations (90) sont espacées autour dudit tube de réaction (20) de telle manière que chacun desdits écoulements en jet (86) rencontre un ou plusieurs autres desdits écoulements en jet pour former une paroi fluide protectrice d'un seul tenant tout en maintenant une énergie cinétique dirigée radialement qui soit suffisante pour repousser lesdits réactifs, et

en ce que la vitesse dirigée radialement de chacun desdits écoulements en jet diminue à l'intérieur dudit tube de réaction (20) sans perturber l'écoulement de fluide à l'intérieur de ladite zone de réaction (29).

2. L'appareil selon la revendication 1, dans lequel chacune desdites multiples perforations (90) à travers ledit tube de réaction (20) est formée autour d'un axe d'ouverture passant sensiblement par ledit axe central (76) dudit tube de réaction (20).

3. L'appareil selon la revendication 1, comprenant de plus:

une première section (118) de tube de réaction de forme cylindrique présentant lesdites perforations (90) espacées sensiblement sur toute la longueur de ladite première section de tube (118) et espacées sensiblement sur tout le périmètre de ladite première section de tube (118), et

une deuxième section de tube de réaction de forme cylindrique (120) espacée an aval de ladite première section de tube et qui est essentiellement non perforée,

ledit flux gazeux inerte, en aval de ladite première section de tube (118), étant sensiblement laminaire afin de maintenir ladite paroi fluide de protection sur toute la longueur de ladite deuxième section de tube (120).

4. L'appareil selon la revendication 2, dans lequel chacune desdites perforations (90) traversant ledit tube de réaction (20) est d'une configuration généralement cylindrique formée autour dudit axe d'ouverture, et présente un diamètre voisin de 0,51 mm ou davantage.

5. L'appareil selon la revendication 2, dans lequel ledit axe d'ouverture de chacune desdites perforations (90) est sensiblement perpendiculaire audit axe central (76) dudit tube de réaction (20).

6. L'appareil selon la revendication 2, dans lequel lesdits multiples perforations (90) sont disposées autour dudit tube de réaction (20) de telle manière que toute ligne d'une surface intérieure (84) dudit tube de réaction (20) passe par plusieurs desdites perforations (90).

7. L'appareil selon la revendication 6, dans lequel lesdites multiples perforations (90) sont situées sur ledit tube de réaction (20) à des noeuds de réseau d'une configuration uniforme en réseau.

8. L'appareil selon la revendication 1, dans lequel le matériau du tube de réaction est d'une conductivité thermique, en direction radiale par rapport audit axe central, d'au moins 27,7 watts/mètre. °C à 2200°C.

9. L'appareil selon la revendication 4, comprenant de plus:

des moyens de conduit (110) pour le passage du gaz inerte vers la surface extérieure de ladite première section de tube cylindrique (118), et

des moyens de barrière (130) pour éviter le flux de gaz inerte depuis ladite surface extérieure de ladite première section (118) de tube cylindrique vers la surface extérieure de ladite deuxième section de tube cylindrique (120).

10. L'appareil selon la revendication 4, dans lequel lesdites multiples perforations (90) possédent chacune des diamètres moyens dans la plage de 0,51 à 2,55 mm, et sont espacées autour dudit tube de réaction (20) à des emplacements sur l'axe de 1,26 mm à 15,3 mm.

11. Un procédé pour former une paroi fluide dans un réateur (10) à haute température du type

16

employant une zone de réaction (29) destinée à introduire des réactifs à l'intérieur d'un tube de réaction (20) et à chauffer ledit tube de réaction (20) à l'incandescence pour émettre un rayonnement radialement vers l'intérieur depuis ledit tube de réaction (20) pour maintenir une réaction chimique souhaitée, caractérisé par les étapes consistant à:

former, à travers ledit tube de réaction (20), plusieurs perforations (90), l'axe de perforation de chacune d'elles étant linéaire,

faire passer un gaz inerte vers l'intérieur à travers lesdites multiples perforations (90) pour former des écoulements en jet de gaz inerte maintenant une énergie cinétique dirigée radialement qui soit suffisante pour repousser lesdits réactifs,

espacer lesdites multiples perforations (90) autour dudit tube de réaction (20) de telle manière que lesdits écoulements en jet se recouvrent pour former une paroi fluide protectrice d'un seul tenant, et

régler la vitesse desdits écoulements en jet de telle manière que la composante radiale de la vitesse desdits écoulements en jets disparaisse sensiblement avant d'atteindre ladite zone de réaction.

12. Le procédé selon la revendication 11, dans lequel chacune desdites multiples perforations (90) à travers ledit tube de réaction (20) est dirigée le long dudit axe de perforation, en passant sensiblement par un axe central (76) dudit tube de réaction (20).

13. Le procédé selon la revendication 11, comprenant de plus les étapes consistant à:
former une première section (118) dudit tube de réaction (20) comportant plusieurs perforations (90),
espacer une deuxième section sans perforations (120) dudit tube de réaction en aval de ladite première section (118), et régler le débit et la température dudit gaz inerte traversant lesdites perforations (90) pour obtenir un flux laminaire en aval de ladite permière section (118) dudit tube de réaction (20) pour maintenir ladite paroi fluide à l'intérieur de ladite deuxième section (120) dudit tube de réaction (20).

14. Le procédé selon la revendication 13, comprenant de plus les étapes consistant à:
faire passer un gaz inerte depuis l'extérieur dudit réacteur (10) pour qu'il vienne en contact avec une chambre au moins partiellement définie par la surface extérieure de ladite première section dudit tube de réaction (20), et
empêcher un flux de gaz inerte depuis ladite surface extérieure de ladite première section (118) dudit tube de réaction (20) vers la surface extérieure de ladite deuxième section (120) dudit tube de réaction (20).

15. Le procédé selon la revendication 12, dans lequel chacune desdites perforations (90) est d'une configuration généralement cylindrique autour dudit axe de perforation, et dans lequel ledit axe de perforation est sensiblement perpendiculaire audit axe central dudit tube de réaction (20).

16. Le procédé selon la revendication 12, comprenant de plus:
un positionnement desdites multiples perforations (90) autour dudit tube de réaction (20) de manière qu'une ligne quelconque de la surface intérieure dudit tube de réaction (20) parallèle audit axe central dudit tube de réaction (20) passe par plusieurs desdites perforations (90).

17. Le procédé selon la revendication 11, comprenant de plus:
la formation desdites multiples perforations (90) traversant ledit tube de réaction (20) possédant chacune un diamètre moyen dans une plage comprise entre 0,51 mm et 2,55 mm, et
un espacement entre lesdites multiples perforations (90) autour dudit tube de réaction à des intervalles, sur l'axe, de 1,6 à 15,3 mm.

18. Le procédé selon la revendication 14, comprenant de plus:
le passage d'un gaz inerte depuis l'extérieur dudit réacteur (10) en contact avec une chambre au moins partiellement définie par la surface extérieure de ladite première section (118) dudit tube de réaction (20), et
le chauffage dudit gaz inerte avant qu'il ne passe dans ladite chambre définie par ladite surface extérieure de ladite première section (118) dudit tube de réaction (20).

19. Le procédé selon la revendication 18, comprenant de plus:
la mise en place d'une troisième section perforée (122) dudit tube de réaction (20) en aval de ladite deuxième section non perforée (120) dudit tube de réaction (20), et
le passage d'un gaz inerte radialement vers l'intérieur à travers les perforations (90) dans ladite troisième section (122) dudit tube de réaction (20) pour maintenir une paroi fluide protectrice pour ladite troisième section (122) dudit tube de réaction (20).

20. Le procédé selon la revendication 11, dans lequel la pression différentielle entre les extrémités du tube de réaction (20) est maintenue dans une plage de 1,3 à 10,1 g/cm$^2$ d'eau lorsque le gaz inerte traverse vers l'intérieur lesdites multiples perforations (90).

21. Le procédé selon la revendication 13, dans lequel l'étape de réglage du débit et de la température du gaz inerte comprend:
un préchauffage du gaz inerte avant le passage du gaz inerte à travers lesdites multiples perforations.

22. Le procédé selon la revendication 13, comprenant de plus:
un isolement substantiel d'une paroi extérieure de ladite première section (118) dudit tube de réaction (20) par rapport à une paroi extérieure de ladite deuxième section (120) dudit tube de réaction (20).

17

FEED
MATERIAL

INERT
GAS

GAS
INPUT

GAS
DISCHARGE

WATER

SOLIDS
DISCHARGE

SOLIDS
DISCHARGE

FIG. 1

FIG. 2

FIG. 3

FIG. 6

FIG. 5

FIG. 4